# EUROPEAN PATENT APPLICATION

(11) **EP 4 756 448 A1**
(43) Date of publication of application: **10.06.2026**
(21) Application number: 24904149.2
(22) Date of filing: 03.12.2024
(51) Int. Cl.: G01R 31/382, G01R 31/396, G01R 19/12, G01R 19/175, G01R 19/165, H01M 10/052

(54) **APPARATUS AND METHOD FOR MANAGING BATTERY**

(30) Priority: 13.12.2023 KR 20230181134
(71) Applicant: LG Energy Solution, Ltd., Seoul 07335 (KR)
(72) Inventor: CHA, A-Ming, Daejeon 34122 (KR); BAE, Yoon-Jung, Daejeon 34122 (KR)
(74) Representative: Goddar, Heinz J.
(86) International application number: PCT/KR2024/019632
(87) International publication number: WO 2025/127584

(57) **Abstract**

The present disclosure relates to a battery management apparatus and method for determining a battery state based on the number of peaks. The battery management apparatus according to an embodiment of the present disclosure includes a profile obtaining unit configured to obtain a differential profile based on a differential voltage and a capacity of a battery; and a control unit configured to calculate the number of peaks included in a target capacity section from the differential profile and determine the type of the battery based on the calculated number of peaks.

## Description

### TECHNICAL FIELD

This application is based on and claims priority from Korean Patent Application No. 10-2023-0181134, filed on December 13, 2023, with the Korean Intellectual Property Office, the disclosure of which is incorporated herein in its entirety by reference.

The present disclosure relates to a battery management apparatus and method, and more particularly, to a battery management apparatus and method for determining a battery state based on the number of peaks.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

These batteries show different voltage profiles indicating the corresponding relationship between voltage and capacity depending on the types of positive and negative electrodes used. If the types of the positive and negative electrodes of the battery are unknown, there is a problem in that the usage conditions of the battery cannot be specifically set. For example, if the types of the positive and negative electrodes of the battery are unknown, there is a problem in that a battery that is not desirable for rapid charging may be equipped in a product that requires rapid charging, and the battery may deteriorate rapidly as it is used. In other words, determining the types of positive and negative electrodes for a battery whose positive and negative electrodes are unknown may be said to be one of the ways to prevent rapid degradation of the battery.

However, while the positive electrode of a battery may be relatively easily distinguished based on the composition of nickel (Ni), it is difficult to determine whether the negative electrode of a battery is a natural graphite-based negative electrode or an artificial graphite-based negative electrode. Therefore, a technology that may determine the type of battery based on the state of the battery is required.

### DISCLOSURE

### Technical Problem

The present disclosure is designed to solve the problems of the related art, and therefore the present disclosure is directed to providing a battery management apparatus and method of determining a state battery based on the number of peaks.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure may comprise: a profile obtaining unit configured to obtain a differential profile based on a differential voltage and a capacity of a battery; and a control unit configured to calculate the number of peaks included in a target capacity section from the differential profile and determine the type of the battery based on the calculated number of peaks.

The control unit may be configured to compare the number of peaks with a preset reference number and determine the type of the battery based on the comparison result.

The control unit may be configured to determine the type of the battery as a natural graphite-based battery or an artificial graphite-based battery based on the comparison result.

The control unit may be configured to determine the type of the battery as a natural graphite-based battery when the number of peaks is greater than or equal to the preset first reference number

The control unit may be configured to determine the type of the battery as the natural graphite-based battery or an artificial graphite-based battery when the number of peaks is less than the first reference number and is equal to a preset second reference number.

The control unit may be configured to determine the type of the battery as the artificial graphite-based battery when the number of peaks is less than the second reference number.

The control unit may be configured to determine the type of the battery as the natural graphite-based battery or the artificial graphite-based battery based on a differential voltage of a plurality of peaks when the number of peaks is equal to the second reference number.

The control unit may be configured to determine the type of the battery as the natural graphite-based battery when a corresponding differential voltage is the same or lower as a capacity corresponding to the plurality of peaks is lower.

The control unit may be configured to determine the type of the battery as the artificial graphite-based battery when the corresponding differential voltage is higher as the capacity corresponding to the plurality of peaks is lower.

The control unit may be configured to determine a target capacity corresponding to a lowest differential voltage in the differential profile and set a capacity section equal to or lower than the determined target capacity as the target capacity section.

The control unit may be configured to divide the entire capacity section of the battery into a lower capacity section and an upper capacity section, and determine the target capacity in the lower capacity section of the differential profile.

A battery pack according to another aspect of the present disclosure may comprise the battery management apparatus according to an aspect of the present disclosure.

A battery management method according to still another aspect of the present disclosure may comprise: a profile obtaining step of obtaining a differential profile based on a differential voltage and a capacity of a battery; a peak number calculating step of calculating the number of peaks included in a target capacity section from the differential profile; and a battery determining step of determining the type of the battery based on the calculated number of peaks.

### Advantageous Effects

According to one aspect of the present disclosure, there is an advantage in that the state of the battery may be determined even without additional measurements or tests being conducted to determine the state of the battery.

In addition, according to one aspect of the present disclosure, since the state of the battery is determined based on the number of peaks, there is an advantage in that the state of the battery may be determined in a non-destructive manner.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIG. 2 is a schematic drawing showing first to fourth batteries according to an embodiment of the present disclosure.
FIG. 3 is a schematic drawing showing a first differential profile of a first battery according to an embodiment of the present disclosure.
FIG. 4 is a schematic drawing showing a second differential profile of a second battery according to an embodiment of the present disclosure.
FIG. 5 is a schematic drawing showing a third differential profile of a third battery according to an embodiment of the present disclosure.
FIG. 6 is a schematic drawing showing a fourth differential profile of a fourth battery according to an embodiment of the present disclosure.
FIG. 7 is a schematic drawing showing a battery pack according to another embodiment of the present disclosure.
FIG. 8 is a diagram schematically showing a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

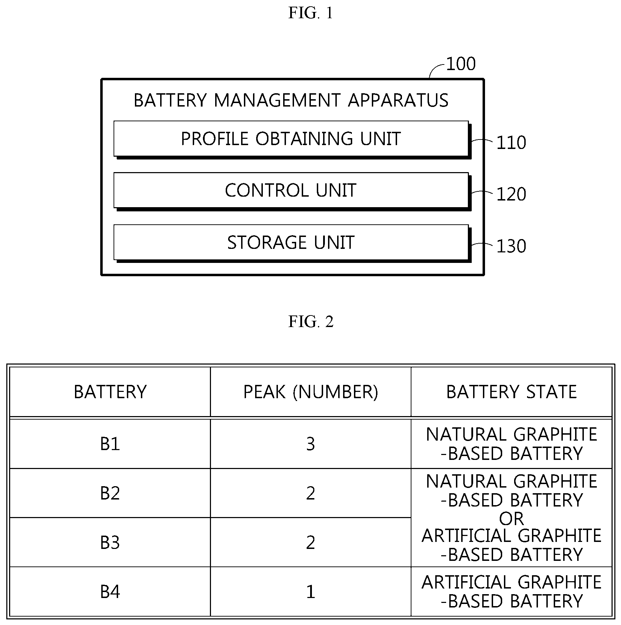

FIG. 1 is a diagram schematically showing a battery management apparatus 100 according to an embodiment of the present disclosure.

Referring to FIG. 1, the battery management apparatus 100 may include a profile obtaining unit 110 and a control unit 120.

Here, a battery means a physically separable independent cell including a negative electrode terminal and a positive electrode terminal. For example, a lithium-ion battery or a lithium polymer battery may be considered a battery. In addition, a battery may mean a battery bank, a battery module, or a battery pack in which a plurality of cells are connected in series and/or in parallel. Hereinafter, for convenience of explanation, a battery is described as meaning a single independent cell.

The profile obtaining unit 110 may be configured to obtain a differential profile based on the differential voltage and capacity of the battery.

Specifically, the battery profile is a profile representing the corresponding relationship between the voltage (V) and the capacity (Q) of the battery. For example, the battery profile may be expressed as a two-dimensional graph in which the X-axis is set to the capacity and the Y-axis is set to the voltage. Then, when the battery profile is differentiated with respect to the capacity, a differential profile representing the corresponding relationship between the differential voltage (dV/dQ) and the capacity (Q) may be generated. Here, the differential voltage (dV/dQ) is a value obtained by differentiating the voltage (V) with respect to the capacity (Q), and may represent the instantaneous rate of change of the voltage with respect to the capacity.

Here, there is no special limitation on the C-rate in charge or discharge for generating a battery profile. However, preferably, the battery should be charged or discharged at a low rate to obtain a more accurate battery profile and differential profile. For example, a battery profile may be generated in the process of charging or discharging a battery at 0.05 C.

For example, the profile obtaining unit 110 may directly receive the differential profile of the battery from the outside. That is, the profile obtaining unit 110 may obtain the differential profile by being connected to the outside by wire and/or wirelessly and receiving the differential profile.

As another example, the profile obtaining unit 110 may receive battery information about the voltage and capacity of the battery. Also, the profile obtaining unit 110 may generate a battery profile based on the received battery information. The profile obtaining unit 110 may generate a differential profile based on the generated battery profile. That is, the profile obtaining unit 110 may obtain a differential profile by directly generating a differential profile based on the battery information.

The profile obtaining unit 110 may be connected to communicate with the control unit 120. For example, the profile obtaining unit 110 may be connected to the control unit 120 by wire and/or wirelessly. The profile obtaining unit may transmit the obtained differential profile to the control unit 120.

The control unit 120 may be configured to calculate the number of peaks included in the target capacity section from the differential profile.

Specifically, the differential profile may include a plurality of peaks. Here, the peak means a point having an upward convex shape among points where the instantaneous rate of change of the differential voltage with respect to the capacity is 0. That is, the instantaneous rate of change of the differential voltage with respect to the capacity on the low capacity side based on the peak is positive, and the instantaneous rate of change of the differential voltage with respect to the capacity on the high capacity side is negative. The control unit 120 may calculate the number of peaks included in the target capacity section among the plurality of peaks included in the differential profile.

FIG. 2 is a schematic drawing showing first to fourth batteries according to an embodiment of the present disclosure.

In the embodiment of FIG. 2, the number of peaks calculated for the first battery B1 is 3, the number of peaks calculated for the second battery B2 is 2, the number of peaks calculated for the third battery B3 is 2, and the number of peaks calculated for the fourth battery is 1.

The control unit 120 may be configured to determine the type of battery based on the calculated number of peaks.

Specifically, the control unit 120 may be configured to compare the number of peaks to a preset reference number.

Here, the reference number may be a value preset to correspond to the type of battery.

For example, in the embodiment of FIG. 2, the number of peaks calculated for the first battery B1 is 3. The control unit 120 may compare the calculated number of peaks (3) with a preset reference number.

The control unit 120 may be configured to determine the type of battery based on the comparison result.

Specifically, the control unit 120 may be configured to determine the type of the battery as a natural graphite-based battery or an artificial graphite-based battery. That is, the control unit 120 may determine the type of the battery as a battery including a natural graphite-based negative electrode or a battery including an artificial graphite-based negative electrode based on the comparison result.

Since natural graphite and artificial graphite have different crystal structures and deterioration patterns, the type of battery must be specifically determined in order to use the battery efficiently. For example, while artificial graphite-based batteries are robust to rapid charging, natural graphite-based batteries have the problem of rapid degradation due to rapid charging.

A situation where a battery is rapidly charged in a state where the type of battery is not specifically determined is assumed. If the battery is an artificial graphite-based battery, the deterioration due to rapid charging will not progress quickly, but if the battery is a natural graphite-based battery, the deterioration due to rapid charging may progress quickly. In other words, in a state where the type of battery is not determined, there is a problem where the life of the battery is reduced by the charging conditions alone.

Therefore, the battery management apparatus 100 has an advantage in that it may determine the type of battery based on the number of peaks included in the differential profile of the battery in a non-destructive manner. Furthermore, the battery management apparatus 100 has an advantage in that it may increase the expected life of the battery by specifically determining the type of the battery.

Meanwhile, the control unit 120 provided in the battery management apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its type as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

A plurality of reference numbers may be preset. Then, the control unit 120 may compare the size of the generated number of peaks with the plurality of reference numbers, and determine the type of battery based on the comparison result.

Here, the type of battery may be determined by each of the plurality of reference numbers. Therefore, preferably, the number of preset reference numbers may be smaller than the number of types of batteries to be determined. For example, if the types of batteries to be determined are two, the number of preset reference numbers may be two. That is, the first reference number and the second reference number may be preset.

The target capacity section of the differential profile may include at least one peak. That is, one of the plurality of reference numbers may be set to distinguish the type of battery corresponding to the minimum value (one) of the calculated number of peaks.

In the following, it is assumed that the first reference number is set to 3 and the second reference number is set to 2. Here, the second reference number may be said to be preset to determine the type of battery corresponding to the minimum value of the calculated number of peaks.

For example, if the number of peaks is greater than or equal to the preset first reference number, the control unit 120 may determine the type of the battery as a natural graphite-based battery. As another example, if the number of peaks is less than the first reference number and is equal to a preset second reference number, the control unit 120 may determine the type of the battery as a natural graphite-based battery or an artificial graphite-based battery. As still another example, if the number of peaks is less than the second reference number, the control unit 120 may determine the type of the battery as an artificial graphite-based battery.

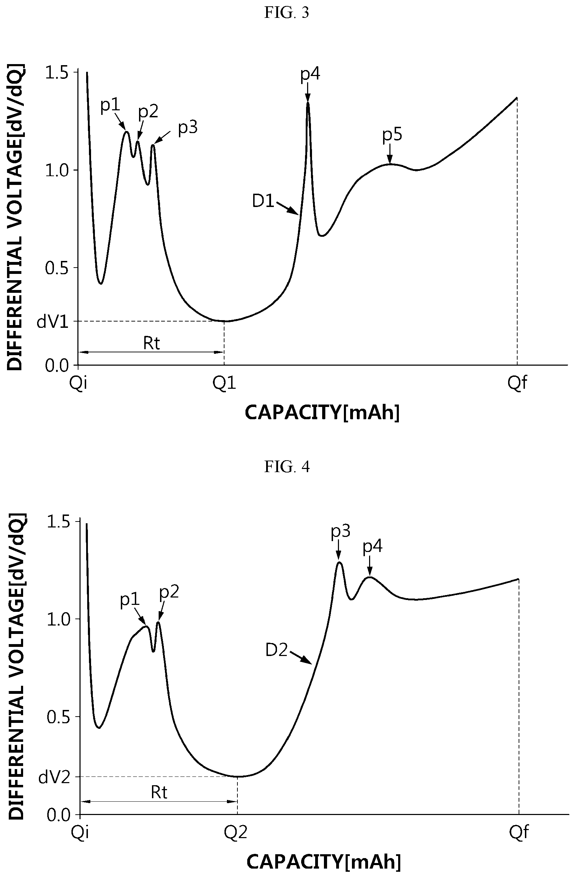

FIG. 3 is a schematic drawing showing a first differential profile D1 of a first battery B1 according to an embodiment of the present disclosure.

In the embodiment of FIG. 3, the first differential profile D1 includes a first peak p1, a second peak p2, a third peak p3, a fourth peak p4, and a fifth peak p5. Specifically, the target capacity section of the first differential profile D1 includes a first peak p1, a second peak p2, and a third peak p3. That is, the control unit 120 may calculate the number of peaks corresponding to the first battery B1 as three. Since the calculated number of peaks is greater than or equal to the preset first reference number, the control unit 120 may determine the type of the first battery B1 as a natural graphite-based battery.

FIG. 4 is a schematic drawing showing a second differential profile D2 of a second battery B2 according to an embodiment of the present disclosure.

In the embodiment of FIG. 4, the second differential profile D2 includes a first peak p1, a second peak p2, a third peak p3, and a fourth peak p4. Specifically, the target capacity section of the second differential profile D2 includes the first peak p1 and the second peak p2. That is, the control unit 120 may calculate the number of peaks corresponding to the second battery B2 as two. Since the calculated number of peaks is less than the first reference number and is equal to the second reference number, the control unit 120 may determine the type of the battery as a natural graphite-based battery or an artificial graphite-based battery.

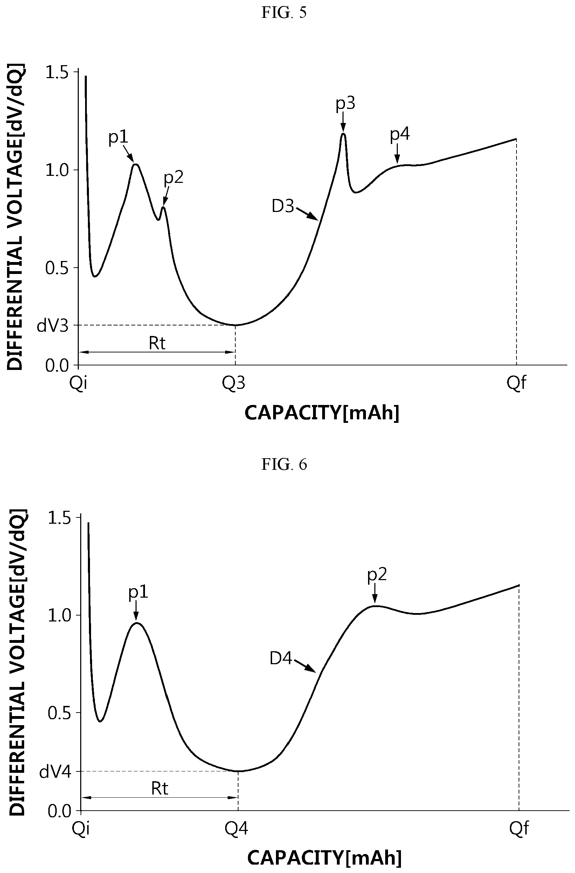

FIG. 5 is a schematic drawing showing a third differential profile D3 of a third battery B3 according to an embodiment of the present disclosure.

In the embodiment of FIG. 5, the third differential profile D3 includes a first peak p1, a second peak p2, a third peak p3, and a fourth peak p4. Specifically, the target capacity section of the third differential profile D3 includes the first peak p1 and the second peak p2. That is, the control unit 120 may calculate the number of peaks corresponding to the third battery B3 as two. Since the calculated number of peaks is less than the first reference number and is equal to the second reference number, the control unit 120 may determine the type of the battery as a natural graphite-based battery or an artificial graphite-based battery.

FIG. 6 is a schematic drawing showing a fourth differential profile D4 of a fourth battery according to an embodiment of the present disclosure.

In the embodiment of FIG. 6, the fourth differential profile D4 includes a first peak p1 and a second peak p2. Specifically, the target capacity section of the fourth differential profile D4 includes the first peak p1. That is, the control unit 120 may calculate the number of peaks corresponding to the fourth battery as 1. Since the calculated number of peaks is less than the second reference number, the control unit 120 may determine the type of the battery as an artificial graphite-based battery.

The control unit 120 may be configured to determine the type of the battery as a natural graphite-based battery or an artificial graphite-based battery based on the differential voltage of the plurality of peaks, if the calculated number of peaks is equal to the second reference number.

Due to the difference in the crystal structure of natural graphite and artificial graphite, the aspects of peaks included in the differential profile of the natural graphite-based battery and peaks included in the differential profile of the artificial graphite-based battery are also different. For example, in the case of the natural graphite-based battery, the differential voltage of a peak on the low capacity side among the peaks included in the target capacity section is equal to or lower than the differential voltage of a peak on the high capacity side. Conversely, in the case of the artificial graphite-based battery, the differential voltage of a peak on the low capacity side among the peaks included in the target capacity section is greater than the differential voltage of a peak on the high capacity side. Therefore, if the calculated number of peaks is equal to the second reference number, the control unit 120 may specifically determine the type of battery by considering the differential voltage of a plurality of peaks.

The control unit 120 may determine the type of the battery as a natural graphite-based battery if the corresponding differential voltage is the same or lower as the capacity corresponding to the plurality of peaks is lower. For example, in the embodiment of FIG. 4, the target capacity section of the second differential profile D2 includes the first peak p1 and the second peak p2. That is, the number of peaks included in the target capacity section of the second differential profile D2 is 2, which is the same as the preset second reference number (2). In addition, since the capacity of the first peak p1 is lower than the capacity of the second peak p2 and the differential voltage of the first peak p1 is lower than the differential voltage of the second peak p2, the control unit 120 may determine the type of the second battery B2 as a natural graphite-based battery.

Conversely, the control unit 120 may determine the type of the battery as an artificial graphite-based battery if the corresponding differential voltage is larger as the capacity corresponding to the plurality of peaks is lower. For example, in the embodiment of FIG. 5, the target capacity section of the third differential profile D3 includes the first peak p1 and the second peak p2. That is, the number of peaks included in the target capacity section of the third differential profile D3 is 2, which is the same as the preset second reference number (2). In addition, since the capacity of the first peak p1 is lower than the capacity of the second peak p2 and the differential voltage of the first peak p1 is higher than the differential voltage of the second peak p2, the control unit 120 may determine the type of the third battery B3 as an artificial graphite-based battery.

That is, when the control unit 120 cannot clearly distinguish a natural graphite-based battery and an artificial graphite-based battery with only the calculated number of peaks, the control unit 120 may specifically determine the type of battery by additionally considering the differential voltage of the calculated peaks.

Below, an embodiment of setting a target capacity section is specifically described.

The control unit 120 may be configured to determine a target capacity corresponding to the lowest differential voltage in the differential profile.

For example, in the embodiment of FIG. 3, the lowest differential voltage of the first differential profile D1 is dV1. The control unit 120 may determine the target capacity corresponding to the lowest differential voltage dV1 as Q1.

The control unit 120 may be configured to set a capacity section equal to or lower than the determined target capacity as the target capacity section.

For example, in the embodiment of FIG. 3, the control unit 120 may set the Qi to Q1 section as the target capacity section. Similarly, in the embodiments of FIGS. 4 to 6, the control unit 120 may determine the target capacities (Q2, Q3, Q4) corresponding to the lowest differential voltages (dV2, dV3, dV4) of the second to fourth differential profiles D4, and set the capacity section equal to or lower than the determined target capacities (Q2, Q3, Q4) as the target capacity section.

The battery management apparatus may determine the type of battery by calculating the number of peaks in the target capacity section. That is, since a process of calculating all peaks in the entire capacity section and then separately selecting only the peaks included in the target capacity section is not required, the battery management apparatus may diagnose the state of the battery more quickly and has the advantage of saving system resources consumed in diagnosing the state of the battery.

The control unit 120 may be configured to divide the entire capacity section of the battery into a lower capacity section and an upper capacity section.

For example, in the embodiment of FIG. 3, the entire capacity section is the Qi to Qf section. The control unit 120 may divide the entire capacity section into two parts, dividing the lower capacity section into the Qi to (Qf-Qi)÷2 section, and the upper capacity section into the (Qf-Qi)÷2 to Qf section. Specifically, the control unit 120 may divide the lower capacity section into a section greater than or equal to Qi and less than or equal to (Qf-Qi)÷2, and the upper capacity section into a section greater than (Qf-Qi)÷2 and less than or equal to Qf.

The control unit 120 may be configured to determine the target capacity in the lower capacity section of the differential profile.

In general, the point corresponding to the lowest differential voltage in the differential profile is included in the lower capacity section. Therefore, the control unit 120 may determine the target capacity section more quickly by determining the target capacity corresponding to the lowest differential voltage in the lower capacity section of the differential profile.

More specifically, if the number of peaks is greater than or equal to the preset first reference number, the control unit 120 may determine the type of the battery as a natural graphite-based battery in the BOL (Beginning of life) state.

As another example, if the number of peaks is less than the first reference number and equal to the preset second reference number, the control unit 120 may determine the type of the battery as a natural graphite-based battery in the MOL (Middle of life) state or an artificial graphite-based battery in the BOL state.

As another example, if the number of peaks is less than the second reference number, the control unit 120 may determine the type of battery as an artificial graphite-based battery in the MOL state.

In the embodiments of FIGS. 3 and 4, the first battery B1 is a natural graphite-based battery of the BOL state, and the second battery B2 is a natural graphite-based battery of the MOL state. In the embodiments of FIGS. 5 and 6, the third battery B3 is an artificial graphite-based battery of the BOL state, and the fourth battery B4 is an artificial graphite-based battery of the MOL state. That is, in both the natural graphite-based battery and the artificial graphite-based battery, as the battery deteriorates, the number of peaks included in the target capacity section may decrease. Therefore, the battery management apparatus 100 has an advantage in that it may specifically determine the state (BOL state or MOL state) and type (natural graphite-based battery or artificial graphite-based battery) of the battery based on the number of peaks included in the target capacity section.

The control unit 120 may be configured to set usage conditions for the battery based on the determined type of battery.

Here, the usage conditions refer to the optimal conditions under which the battery may be used, and may be conditions set for the charge/discharge C-rate and/or available SOC section of the battery.

The control unit 120 may be configured to set usage conditions for the battery so that the battery is charged and discharged below a predetermined C-rate when the type of the battery is determined to be a natural graphite-based battery. For example, the predetermined C-rate may be set to 1 C or more.

A battery including a natural graphite-based negative electrode may degrade faster than a battery including an artificial graphite-based negative electrode when charged or discharged at a high C-rate. Therefore, if the control unit 120 determines that the type of battery is a natural graphite-based battery, it is possible to induce the battery to degrade more slowly in a situation in which the battery is actually used by setting the charge/discharge C-rate for the battery to be lower than a predetermined C-rate.

The control unit 120 may be configured to set usage conditions for the battery so that the battery is charged and discharged at a predetermined C-rate or higher when the type of the battery is determined to be an artificial graphite-based battery.

An artificial graphite-based battery may deteriorate more slowly than a natural graphite-based battery even when charged or discharged at a high C-rate. Therefore, if the control unit 120 determines that the type of battery is an artificial graphite-based battery, it is possible to induce the charge/discharge efficiency of the battery to be improved in a situation where the battery is actually used by setting the charge/discharge C-rate for the battery to a predetermined C-rate or higher.

That is, the battery management apparatus 100 has an advantage in that it is possible to prevent rapid deterioration of the battery in an actual use environment by setting the usage conditions for the battery to correspond to the determined type of battery.

Meanwhile, for example, the usage conditions set for the battery may be stored in the control unit 120 or the storage unit 130. As another example, the usage conditions set for the battery may be transmitted to an external server by the control unit 120, and the external server may store the usage conditions for the battery.

In addition, the battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

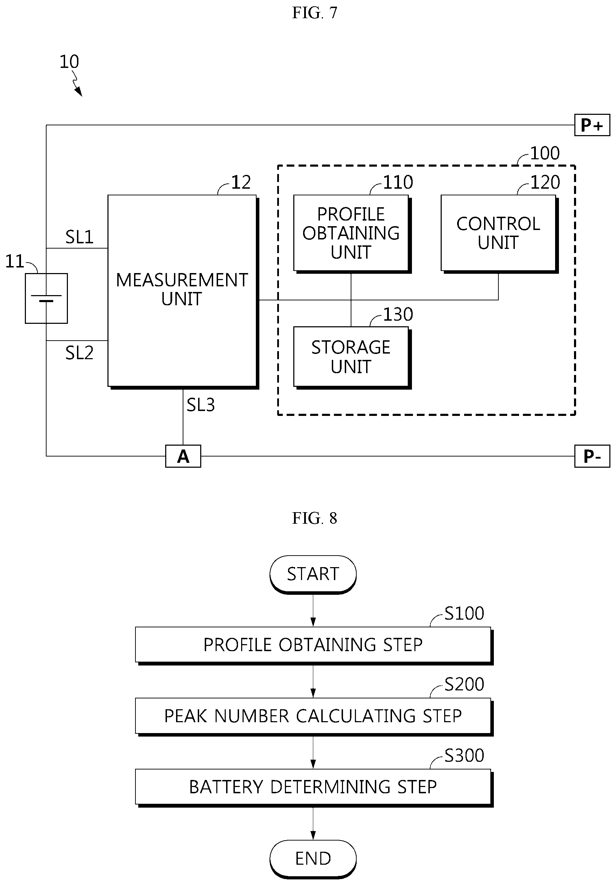

FIG. 7 is a diagram showing an exemplary configuration of a battery pack including the battery management apparatus 100 according to an embodiment of the present disclosure.

The positive electrode terminal of the battery 11 may be connected to the positive electrode terminal P+ of the battery pack 1, and the negative electrode terminal of the battery 11 may be connected to the negative electrode terminal P- of the battery pack 1.

A measurement unit 12 may be connected to a first sensing line SL1, a second sensing line SL2, and a third sensing line SL3. Specifically, the measurement unit 12 may be connected to a positive electrode terminal of the battery 11 through the first sensing line SL1, and may be connected to a negative electrode terminal of the battery 11 through the second sensing line SL2. The measurement unit 12 may measure the voltage of the battery 11 based on the voltage measured at each of the first sensing line SL1 and the second sensing line SL2.

In addition, the measurement unit 12 may be connected to an ampere meter A through the third sensing line SL3. For example, the ampere meter A may be an ammeter or a shunt resistor capable of measuring the charging current and the discharging current of the battery 11. The measurement unit 12 may calculate the charge amount by measuring the charging current of the battery 11 through the third sensing line SL3. Also, the measurement unit 12 may calculate the discharge amount by measuring the discharge current of the battery 11 through the third sensing line SL3.

One end of the load 2 may be connected to the positive electrode terminal P+ of the battery pack 1, and the other end may be connected to the negative electrode terminal P-of the battery pack 1. Accordingly, the positive electrode terminal of the battery 11, the positive electrode terminal P+ of the battery pack 1, the load 2, the negative electrode terminal P- of the battery pack 1, and the negative electrode terminal of the battery 11 may be electrically connected.

FIG. 8 is a diagram schematically showing a battery management method according to another embodiment of the present disclosure.

Referring to FIG. 8, the battery management method may include a profile obtaining step (S100), a peak number calculating step (S200), and a battery determining step (S300).

Preferably, each step of the battery management method may be performed by the battery management apparatus 100. Hereinafter, for convenience of explanation, contents overlapping with the previously described contents will be omitted or briefly described.

The profile obtaining step (S100) is a step of obtaining a differential profile based on differential voltage and capacity of the battery, and may be performed by the profile obtaining unit 110.

For example, the profile obtaining unit 110 may directly receive the differential profile of the battery from the outside. That is, the profile obtaining unit 110 may obtain the differential profile by being connected to the outside by wire and/or wirelessly and receiving the differential profile.

As another example, the profile obtaining unit 110 may receive battery information about the voltage and capacity of the battery. Here, the battery information may be divided into information corresponding to a charging process and information corresponding to a discharging process. In addition, the profile obtaining unit 110 may obtain a differential profile by directly generating a differential profile based on the battery information.

The peak number calculating step (S200) is a step of calculating the number of peaks included in a target capacity section from the differential profile, and may be performed by the control unit 120.

For example, in the embodiment of FIG. 3, the control unit 120 may calculate the number of peaks included in the target capacity section Rt of the first differential profile D1 as three.

For example, in the embodiment of FIG. 4, the control unit 120 may calculate the number of peaks included in the target capacity section Rt of the second differential profile D2 as two.

For example, in the embodiment of FIG. 5, the control unit 120 may calculate the number of peaks included in the target capacity section Rt of the third differential profile D3 as two.

For example, in the embodiment of FIG. 6, the control unit 120 may calculate the number of peaks included in the target capacity section Rt of the fourth differential profile D4 as one.

The battery determining step (S300) is a step of determining a battery state based on the calculated number of peaks, and may be performed by the control unit 120.

Specifically, the control unit 120 may be configured to compare the calculated number of peaks with a preset reference number and determine the type of the battery as a natural graphite-based battery or an artificial graphite-based battery based on the comparison result.

For example, in the embodiment of FIG. 3, since the number of peaks included in the target capacity section Rt is 3, the control unit 120 may determine the type of the first battery as a natural graphite-based battery. More specifically, the control unit 120 may determine the first battery as a natural graphite-based battery in a BOL state.

For example, in the embodiment of FIG. 4, the number of peaks included in the target capacity section Rt is 2. Also, the differential voltage of the first peak is lower than the differential voltage of the second peak. Therefore, the control unit 120 may determine the type of the second battery as a natural graphite-based battery. More specifically, the control unit 120 may determine the second battery as a natural graphite-based battery in a MOL state.

For example, in the embodiment of FIG. 5, the number of peaks included in the target capacity section Rt is 2. Also, the differential voltage of the first peak is higher than the differential voltage of the second peak. Therefore, the control unit 120 may determine the type of the third battery as an artificial graphite-based battery. More specifically, the control unit 120 may determine the third battery as an artificial graphite-based battery in a BOL state.

For example, in the embodiment of FIG. 6, since the number of peaks included in the target capacity section Rt is 1, the control unit 120 may determine the type of the fourth battery as an artificial graphite-based battery. More specifically, the control unit 120 may determine the fourth battery as an artificial graphite-based battery in a MOL state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
12: measurement unit
100: battery management apparatus
110: profile obtaining unit
120: control unit
130: storage unit

## Claims

1. A battery management apparatus, comprising:
a profile obtaining unit configured to obtain a differential profile based on a differential voltage and a capacity of a battery; and
a control unit configured to calculate the number of peaks included in a target capacity section from the differential profile and determine the type of the battery based on the calculated number of peaks.

2. The battery management apparatus according to claim 1,
wherein the control unit is configured to compare the number of peaks with a preset reference number and determine the type of the battery based on the comparison result.

3. The battery management apparatus according to claim 2,
wherein the control unit is configured to determine the type of the battery as a natural graphite-based battery or an artificial graphite-based battery based on the comparison result.

4. The battery management apparatus according to claim 2,
wherein the control unit is configured to:
determine the type of the battery as a natural graphite-based battery when the number of peaks is greater than or equal to the preset first reference number,
determine the type of the battery as the natural graphite-based battery or an artificial graphite-based battery when the number of peaks is less than the first reference number and is equal to a preset second reference number, and
determine the type of the battery as the artificial graphite-based battery when the number of peaks is less than the second reference number.

5. The battery management apparatus according to claim 4,
wherein the control unit is configured to determine the type of the battery as the natural graphite-based battery or the artificial graphite-based battery based on a differential voltage of a plurality of peaks when the number of peaks is equal to the second reference number.

6. The battery management apparatus according to claim 5,
wherein the control unit is configured to:
determine the type of the battery as the natural graphite-based battery when a corresponding differential voltage is the same or lower as a capacity corresponding to the plurality of peaks is lower, and
determine the type of the battery as the artificial graphite-based battery when the corresponding differential voltage is higher as the capacity corresponding to the plurality of peaks is lower.

7. The battery management apparatus according to claim 1,
wherein the control unit is configured to determine a target capacity corresponding to a lowest differential voltage in the differential profile and set a capacity section equal to or lower than the determined target capacity as the target capacity section.

8. The battery management apparatus according to claim 7,
wherein the control unit is configured to divide the entire capacity section of the battery into a lower capacity section and an upper capacity section, and determine the target capacity in the lower capacity section of the differential profile.

9. A battery pack comprising the battery management apparatus according to any one of claims 1 to 8.

10. A battery management method comprising:
a profile obtaining step of obtaining a differential profile based on a differential voltage and a capacity of a battery;
a peak number calculating step of calculating the number of peaks included in a target capacity section from the differential profile; and
a battery determining step of determining the type of the battery based on the calculated number of peaks.
